(19) Europäisches Patentamt
European Patent Office
Office européen des brevets

(11) **EP 4 608 116 A1**

(12) **EUROPEAN PATENT APPLICATION**

(43) Date of publication:
**27.08.2025 Bulletin 2025/35**

(21) Application number: **24159680.8**

(22) Date of filing: **26.02.2024**

(51) International Patent Classification (IPC):
**H10N 60/12** (2023.01)  **H10N 69/00** (2023.01)
**G06N 10/40** (2022.01)

(52) Cooperative Patent Classification (CPC):
**H10N 60/12; G06N 10/40; H10N 69/00**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicants:
• **Universität Hamburg**
**20148 Hamburg (DE)**

• **University of South-Eastern Norway**
**3616 Kongsberg (NO)**

(72) Inventors:
• **BLICK, Robert**
**22763 Hamburg (DE)**
• **MASSEL, Francesco**
**3614 KONGSBERG (NO)**

(74) Representative: **Eisenführ Speiser**
**Patentanwälte Rechtsanwälte PartGmbB**
**Postfach 10 60 78**
**28060 Bremen (DE)**

(54) **SUPERCONDUCTING DEVICE AND CONTROL THEREOF**

(57)  The invention relates to a device comprising a first part 10, 40, a second part 20, 50 and a third part 30, 60 of superconducting material, wherein the third part 30, 60 is arranged between the first part 10, 40 and the second part 20, 50 such that a first Josephson junction 13, 46 is formed by the first part 10, 40 and the third part 30, 60 and a second Josephson junction 32, 65 is formed by the second part 20, 50 and the third part 30, 60. The third part 30, 60 is arranged such that it is capable of carrying out mechanical oscillations between the first part 10, 40 and the second part 20, 50, wherein the mechanical oscillations change a respective physical dimension of the first Josephson junction 13, 46 and the second Josephson junction 32, 65.

Fig. 1

**Description**

FIELD OF THE INVENTION

The invention relates to a device with superconducting parts, a control apparatus for controlling the device, a quantum computing apparatus comprising the device and the control apparatus, to a control method for controlling the device, and to a use of the quantum computing apparatus.

BACKGROUND OF THE INVENTION

A Josephson junction is a type of electronic device made from two superconducting parts separated by non-superconducting material, such as by a thin insulating layer or a non-superconducting metal. Josephson junctions exhibit a number of unique and interesting properties due to the quantum mechanical effects of superconductivity. One of the most important properties of a Josephson junction is the ability to externally control a supercurrent, which is a current of Cooper pairs - pairs of electrons that are bound together by the attractive force between them in a superconductor. This supercurrent can flow without any resistance through the Josephson junction, and is highly sensitive to changes in the phase difference between the superconducting parts.

The dynamics of the supercurrent that flows across the junction is related to the phase difference between the superconductors, and is described by the Josephson equation. This equation shows that the current can be highly sensitive to even very small changes in the phase difference, and this sensitivity can be used to create highly accurate voltage standards and other sensitive measurement devices. Josephson junctions also have a number of other interesting properties, including the ability to act as fast-switching devices. They have been used in a variety of applications, including superconducting digital circuits, magnetic field sensors and quantum computing devices, particularly as superconducting quantum bits.

Superconducting quantum bits (qubits) are a type of quantum bit used in quantum computing. They are made from superconducting materials, which are materials that can conduct electricity with zero resistance at sufficiently low temperatures. Typically, superconducting qubits are made from one or more Josephson junctions, and are designed to exploit the principles of quantum mechanics, allowing for the creation of quantum states that can be used to store and manipulate information.

One of the key advantages of superconducting qubits with respect to other quantum computing platforms is that they can be fabricated using standard semiconductor fabrication techniques, which makes them relatively easy to scale up and integrate with other components of a quantum computer. However, on the way towards the development of fault-tolerant quantum computers, further improvements in the ability to store and manipulate quantum information are needed.

SUMMARY OF THE INVENTION

*1. As a quantum computing device*

It is an object of the invention to provide a device that allows for an improved storage and manipulation of quantum information.

In a first aspect, the invention relates to a device comprising a first part, a second part and a third part of superconducting material. That is to say, each of the first, the second and the third part is a part of superconducting material. The third part is arranged between the first part and the second part such that a first Josephson junction is formed by the first part and the third part and a second Josephson junction is formed by the second part and the third part. Moreover, the third part is arranged such that it is capable of carrying out mechanical oscillations between the first part and the second part, wherein the mechanical oscillations change a respective physical dimension of the first Josephson junction and the second Josephson junction.

Since the third part of superconducting material of the device forms a Josephson junction with each of the first and the second part of superconducting material of the device and since the third part is arranged such that it is capable of carrying out mechanical oscillations between the first part and the second part, wherein the mechanical oscillations change the physical dimensions of the two Josephson junctions, the device can realize a coupled system comprising a superconducting qubit and a bosonic system coupled to each other. Coupling bosonic systems to qubits is considered to be advantageous for quantum error correction, i.e., for preventing loss of quantum information from a quantum computing device. When compared with qubit-based error correcting schemes, quantum error correction with bosonic systems leads to a reduction of the number of needed electric and/or superconducting circuit elements and gives the possibility of realizing different error correcting schemes.

Since the third part of superconducting material of the device presented herein is capable of carrying out mechanical oscillations, it forms a mechanical oscillator that can be used as a bosonic system for quantum error correction.

Besides potentially leading to new quantum error correction protocols and hence allowing for an improved manipulation of quantum information, this has been found to allow for a two-fold advantage: firstly, mechanical resonators allow for excitations having relatively long lifetimes (compared, for instance, with microwave cavities), such that quantum states can be stored in a mode, i.e., a mechanical mode, thereof for a relatively long time. Secondly, mechanical oscillators -unlike microwave cavities - can be arranged relatively close to each other without generating interference. The device presented herein, with its third part of superconducting material acting as a mechanical oscillator, can therefore be potentially scaled to a system including hundreds of devices, i.e., copies of the device.

The two-fold advantage of using a mechanical oscillator for bosonic quantum error correction can be exemplified particularly in relation to known systems where a microwave cavity is used as bosonic system instead. Achievable mechanical linewidths can be estimated around or below ~ 100 Hz, whereas cavity linewidths tend to lie at - 10 kHz, which translates into larger coherence times of mechanical oscillators as compared to microwave cavities. Additionally, less "cross-talk" between mechanical modes can be observed as compared to electromagnetic modes. Furthermore, from a manufacturing point of view mechanical oscillators allow for a better scalability than microwave cavities.

## 2. In metrology and sensing

Notably, while the device presented herein has so far been presented as being particularly useful for quantum information manipulation and storage and could therefore also be referred to as a quantum computing device, its use for quantum computing is not the only possibility. In fact, the device presented herein is considered to have a large number of possible applications. For instance, apart from quantum computing, the device may be applied in metrology and in ultra-sensitive detectors such as superconducting quantum interference devices (SQUIDs). The third part of superconducting material may, in an embodiment, also be referred to as a nano-mechanical oscillator, or resonator. Since, moreover, the oscillator can be understood as being part of two Josephson junctions and since the resulting circuit can be controlled and/or tuned, the Josephson junctions may also be referred to as nano-mechanically tunable Josephson junctions. Accordingly, where, for instance, the device is of a SQUID-type, it could be referred to as a nano-mechanically controlled SQUID.

## 3. Particular technical aspects

Also the first and the second part of superconducting material may form a Josephson junction. Then, not all Cooper pairs traveling from the first to the second part of superconducting material or vice versa necessarily travel via the third part of superconducting material. Since, however, the third part of superconducting material is arranged between the first part and the second part, travel paths of Cooper pairs from the first part to the second part or vice versa via the third part should be more frequent, at least in a region where the third part is arranged between the first and the second part. In any case, the coupling between the superconducting qubit and the mechanical oscillator may preferably be described without reference to a Josephson junction being formed between the first part and the second part of superconducting material, but instead with reference to the first Josephson junction and the second Josephson junction, since the properties of the first and the second Josephson junction will depend more substantially on the mechanical oscillations of the third part of superconducting material.

Typically, the device further comprises an insulating substrate, wherein the first, the second and the third superconducting part are arranged on the substrate. Known substrates can be used, such as silicon substrates with a silicon oxide layer on top. The substrate is insulating, since in this way it can be made sure that any current will flow through the superconducting parts, i.e., that a supercurrent flows through the device. Particularly preferred for quantum computing applications may be substrates for which a number of trapped charges in the substrate is relatively low. Trapped charges in the substrate are expected to have a detrimental influence in quantum computing applications of the device presented herein.

Regarding the arrangement of the third part between the first and the second part such that the third part is capable of carrying out mechanical oscillations between the first part and the second part, the device may be manufactured as described, for instance, in any of the following publications, which are herewith incorporated in their entirety by reference:

- 'A Mode Locked Nanomechanical Electron Shuttle', D.V. Scheible and R.H. Blick, New Journal of Physics, January 12, 023019 (2010),

- 'Coulomb-controlled Single Electron Field Emission from a Freely Suspended Metallic Island', C. Kim, H.S. Kim, H. Qin, and R.H. Blick, Nano Letters 10, 615 (2010),

- 'Periodic Field Emission from an Isolated Nanoscale Electron Island', D.V. Scheible, Ch. Weiss, J.P. Kotthaus, and R.H. Blick, Physical Review Letters 93, 186801 (2004),

- 'Effects of Low Attenuation in a Nanomechanical Electron Shuttle', D.V. Scheible, Ch. Weiss, and R.H. Blick, Journal of Applied Physics 96, 1757 (2004),

- 'A Quantum Electro Mechanical Device: The Electro-Mechanical Single Electron Pillar', Robert H. Blick and D.V. Scheible, Superlattices and Microstructures 33, 397 (2004), and

- 'Silicon Nano-Pillars for mechanical single electron transport', D.V. Scheible and R.H. Blick, Applied Physics Letters 84, 4632 (2004).

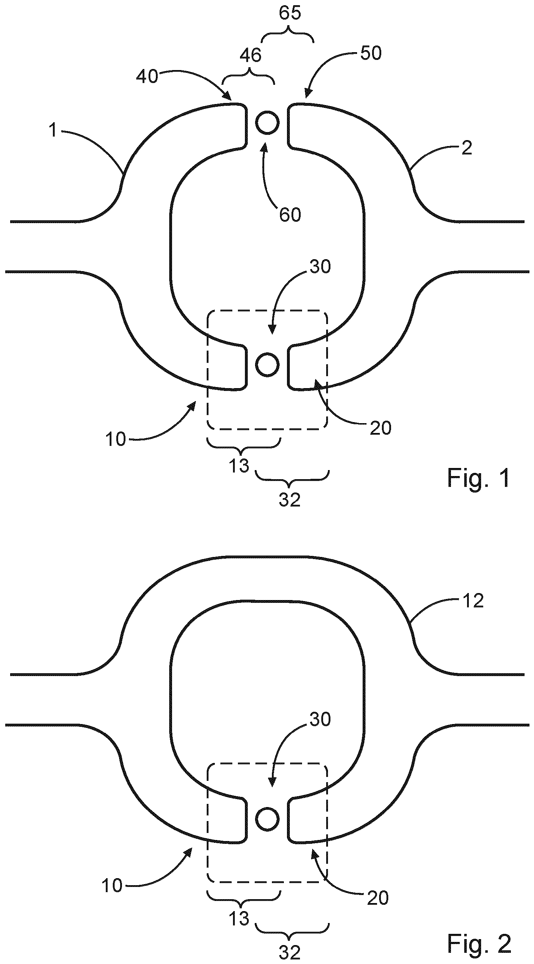

Based on these references, the third part of superconducting material can correspond to a tip or distal end section of an arm that is, at an opposite end, fixed to a substrate but is otherwise free to oscillate (see, for instance, the metallic islands/resonator shuttles in Figure 1 of the first of the above mentioned publications). An exemplary further option is to glue the third part to the first and the second part with a material such as Teflon, which is flexible enough to still allow for mechanical oscillations (see, for instance, the Figure 1 of the second of the above mentioned publications).

Contrary to what is discussed in the references above, where ordinary metals are used for forming the respective circuit parts, superconducting materials such as, for instance, aluminum (Al) or niobium (Nb), are used for the first, the second and the third part of superconducting material of the device presented herein. The respective circuit parts of the above publications could be, for instance, replaced by superconducting metal parts. However, it is also possible that the respective circuit parts are just supplemented by one or more layers of superconducting material.

It may be preferred that the first part is a part of a first superconductor and the second part is a part of a second superconductor formed non-integrally with the first superconductor. In other words, the first part of superconducting material and the second part of superconducting material are in this case not part of a same, i.e., integrally-formed, superconductor. The first and the second superconductor being formed non-integrally with each other could therefore also be referred to as being separate from each other, i.e., as being separate pieces of superconducting material. Where the two superconductors approach each other, a third part of superconducting material may be inserted between them, which could then be regarded as a superconducting island between the two superconductors.

The two superconductors may be formed such that they approach each other at more than one position. For instance, to allow for a DC SQUID-like operation of the device proposed herein, each Josephson junction in an ordinary DC SQUID may be replaced with a (superconducting) island free to oscillate between two portions of superconducting material. Hence, an ordinary DC SQUID is viewed herein as a case of two separate superconductors approaching each other at two different positions, i.e., Josephson junctions.

Thus, a first superconductor and a second superconductor formed non-integrally with the first superconductor can be arranged such that each of two first parts of the first superconductor forms, with a respective one of two second parts of the second superconductor and additionally a respective third part of superconducting material (i.e., a respective superconducting island), an arrangement as described above. In particular, the first and the second superconductor can be arranged such that the first parts approach the second parts, wherein the first parts "approaching" the second parts can be understood such that, as compared to remaining parts of the superconductors, the first and the second parts are arranged relatively closely to each other, particularly such that they form respective Josephson junctions, at least with a respective third part of superconducting material in between. Such a configuration could be said to realize two Josephson junctions "in parallel".

The number of positions where the two superconductors approach each other may also be higher than two. Thus, the DC SQUID-like arrangement can be generalized with the inclusion of three or more superconducting island structures.

Also the number of superconductors, i.e., integrally formed parts of superconducting material, may be higher. However, irrespective of the number of superconductors, it may be preferred that the device comprises at least two sets of first parts, second parts and third parts, such that a respective version of the arrangement defined above for the first part, the second part and the third part of superconducting material is present at two or more locations of the device. In this way, further bosonic degrees of freedom can be provided, which can further improve the possibilities of storing quantum information in the device.

According to generalizations to higher number of superconductors, for instance, at least two versions of the arrangement of a first, a second and a third part of superconducting material as described above may be formed by an equal number of superconductors. Hence, for instance, two versions of the arrangement may be formed by two superconductors, three versions of the arrangement may be formed by three superconductors, four versions by four superconductors, et cetera. In this way, "star-like" configurations of superconducting material with respective Josephson junctions in between might be formed, for instance.

On the other hand, it is also an option that the number of versions of the arrangement of a first, a second and a third part of superconducting material described above and the number of separate pieces of superconducting material present in the device are not equal to each other. For instance, two superconductors might be arranged in the shape of two "opposing forks", wherein respective third parts of superconducting material may be arranged between pairwise approaching points of the two "forks".

In order to allow the device to function as an RF-SQUID, it may be preferred that the first part and the second part are parts of a same superconductor. In other words, the first part and the second part of superconducting material would be parts of a single, integrally formed superconductor. For instance, the first and the second part may be respective ends of a piece of superconducting material, wherein the ends approach each other. Hence, the piece of superconducting material may be bent. Between the approaching ends, the third part of superconducting material may be arranged. In particular, the superconductor may comprise a ring-like shape as in a known RF-SQUID, wherein a part of superconducting material is placed inside the Josephson junction of the RF-SQUID to form a superconducting island.

The advantage of increasing the number of arrangements of this kind in the device and/or varying the geometrical configuration of superconducting material depends on the application. In particular, the topology of the configuration of superconducting material in the device is relevant. For instance, the superconducting material of the device may be, apart from the one or more Josephson junctions, topologically ring-like, i.e., may have, apart from the one or more Josephson junctions, the topology of a closed loop.

A more geometrical aspect is the exact size of the several parts of superconducting material involved, including their relative sizes. For instance, the shape of the one or more third parts of superconducting material is generally not limited. In particular, a respective third part may be arranged between the respective first part and the respective second part along a direction of current flow, wherein an extent of the first, the second and the third part in a direction perpendicular to the current flow may be equal or at least similar. Likewise, however, the extent of the third part in the direction perpendicular to the current flow may be smaller than the extent of the first and/or the second part in the direction perpendicular to the current flow. For instance, the extent of the third part in the direction perpendicular to the current flow may be equal or similar to a distance (e.g., an equilibrium or average distance) of the third part to the first and/or the second part in the direction of the current flow, whereas the extent of the first and/or the second part in the direction perpendicular to the current flow may be larger than the distance of the third part to the first and/or the second part in the direction of the current flow.

The device may further comprise a voltage source electrically connected to the at least one first part and the at least one second part of superconducting material such that the voltage source is controllable to generate and/or change a voltage between a) the at least one first part and/or the at least one second part and b) at least one third part. Hence, a voltage across the respective first and second Josephson junction can be controlled. In this way, the AC Josephson effect can be employed. Without a voltage across the respective Josephson junction, the DC Josephson effect can be employed.

In embodiments with more than one pair of a respective first part of superconducting material and a respective second part of superconducting material, the voltage source may be connected to the one or more superconductors such that it is controllable to selectively generate and/or change a voltage between a) the respective first part and/or the respective second part of superconducting material of any of the pairs and b) the respective third part of superconducting material in between individually. In other words, if the device comprises more than one Josephson junction with a respective superconducting island, the voltages at the Josephson junctions can be the same or different from each other.

It may also be preferred to control a voltage between a respective first part of superconducting material and a respective second part of superconducting material, which may also be viewed as a voltage across the respective Josephson junction. Thus, in particular, the voltage source may be controlled such that the first and second parts of superconducting material are not at a same electric potential.

While the at least one first and the at least one second part can be electrically connected to a voltage source, the at least one third part of superconducting material is preferably grounded, i.e., electrically grounded. Hence, for instance, the voltage source may be used to generate a same electric potential on each of the at least one first and the at least one second part, wherein this electric potential may correspond to the voltage between a) each of the at least one first and the at least one second part and b) the respective grounded third part in between.

Regarding the AC Josephson effect, it should be noted that the frequency f of the supercurrent across the respective Josephson junctions depends on the voltage V across the junction in the way $f = 2eV/h$, where $2e/h$ is approximately 484 GHz/mV. The resulting qubit frequencies are relatively high (e.g., approximately 20 times as high) as compared to those achievable by a nano-mechanical resonator realized with a third part of superconducting material. Despite the resulting relatively large frequency mismatch between the qubit and the mechanical resonator, the two can be coupled by modulating a magnetic flux through the device. In this way, flux-driven side-band transitions can be induced.

The device preferentially further comprises a first capacitance providing element through which the voltage source is electrically connected to the at least one first part and the at least one second part of superconducting material. Moreover, in order to allow the device to function as a transmon-like device it can be preferred that the device further comprises a second capacitance providing element, wherein the second capacitance providing element could be regarded as being electrically installed in parallel to the first capacitance providing element. The second capacitance providing element may be electrically connected to the at least one first part and the at least second part via a same electric connection as the voltage source and the first capacitance providing element. In particular, however, in between the voltage source and the second capacitance providing element, an electric grounding may be provided. Hence, the voltage source and the second capacitance providing element may be electrically grounded to a common ground, wherein otherwise the second capacitance providing element may be directly electrically connected to the at least one first part and the at least one second part of superconducting material, whereas the voltage source may be electrically connected to the at least one first part and the at least one second part of superconducting material via the first capacitance providing element. The voltage source and the second capacitance providing element may be grounded to the common ground via a same electric grounding connection as the at least one third part of superconducting material.

The first and the second capacitance providing element may each comprise a plurality of electric elements. Hence, they are not limited to being a respective single electric element. The term "element" as used herein can therefore be understood in the sense of lumped-element models.

In the presence of both a first capacitance providing element and a second capacitance providing element, the device is less sensitive to environmental charge noise. However, the device may, in principle, also comprise the first capacitance providing element without the second capacitance providing element, for instance.

*4. Device Control*

In a further aspect, the invention relates to a control apparatus for controlling the device. The control apparatus comprises a) a field generating element for generating a magnetic field corresponding to a magnetic flux through the device. Moreover, the control apparatus comprises b) a control unit configured to control a state of the device based on a model of the device, wherein the model represents the device as a superconducting circuit coupled to a mechanical oscillator such that the coupling depends on the magnetic flux. The control unit is configured to control the state of the device by controlling the coupling between the superconducting circuit and the mechanical oscillator using the field generating element.

It has been found that by an external magnetic field corresponding to a magnetic flux through the device, an interaction between a) a respective first and second part of superconducting material and b) a respective third part of superconducting material can be changed, such that the device can be understood as a superconducting circuit, particularly a superconducting qubit, being tunably coupled to a mechanical oscillator, wherein the coupling is tunable via the external magnetic field.

The control unit may furthermore be configured to control a voltage source of the device as mentioned above. The voltage source may also be part of the control apparatus instead of the device. As explained above, also via the voltage generated by the voltage source, i.e., via a voltage between a) the at least one first part and the at least one second part and b) at least one third part, the state of the device can be controlled, particularly the coupling between the superconducting circuit and the mechanical oscillator.

The field generating element is preferably adapted to generate the magnetic field corresponding to the magnetic flux independently from the voltage source, the first capacitance providing element and the second capacitance providing element. For generating the magnetic field corresponding to the magnetic flux, the field generating element may comprise an electric circuit that is different from an electric circuit which the voltage source, the first capacitance providing element and the second capacitance providing element may form. In fact, known means for generating the magnetic field corresponding to the magnetic flux may be used in, or as, the field generating element, such as one or more electromagnetic coils, for instance.

In embodiments where the superconducting material of the device has the topology of a ring, the magnetic flux can particularly be a magnetic flux through the ring. That is to say, assuming the superconducting material is arranged in a circuit plane, which may correspond to a plane of a substrate on which the superconducting material is arranged, the generated magnetic field may preferably be, or at least have a component that is, perpendicular to the circuit plane, wherein the magnetic field may furthermore, in the direction of the circuit plane, extend over a whole region where the superconducting material forms the topology of a ring.

The device can be described through a quantum mechanical model defined such that it treats the superconducting circuit as a qubit and the mechanical oscillator as a quantum harmonic oscillator. In this way, an efficient representation of the possible states of, and interactions in, the device can be established, which allows to control the device, particularly regarding applications thereof for quantum computing.

*5. Further aspects of the invention*

The invention also relates to a quantum computing apparatus comprising the device and the control apparatus. In particular, the apparatus can comprise a plurality of versions of the device as described above, all arranged on a common substrate and controllable by the control apparatus.

A further aspect of the invention relates to a control method for controlling the device, including steps of a) generating a magnetic field corresponding to a magnetic flux through the device, and b) controlling a state of the device based on a model of the device, wherein the model represents the device as a superconducting circuit coupled to a mechanical oscillator such that the coupling depends on the magnetic flux, wherein the control unit is configured to control the state of the device by controlling the coupling between the superconducting circuit and the mechanical oscillator using the magnetic field.

Furthermore, the invention relates, in an aspect, to a use of the quantum computing apparatus for quantum computing. This use may involve carrying out the above method.

It shall be understood that the device of claim 1, the apparatus of claim 11, the method of claim 12 and the use according to claim 13 have similar and/or identical preferred embodiments as defined in the dependent claims.

It shall be understood that a preferred embodiment of the invention can also be any combination of the dependent claims with the respective independent claim.

These and other aspects of the invention will be apparent from and elucidated with reference to the embodiments described hereinafter.

In the following, the present disclosure is further described with reference to the enclosed figures. The same reference numbers in the drawings and this disclosure are intended to refer to the same or like elements, components, and/or parts.

BRIEF DESCRIPTION OF THE DRAWINGS

Fig. 1     shows schematically and exemplarily a device comprising two superconductors approaching each other at two locations, wherein at each of the two locations an oscillating part of superconducting material is arranged between the two superconductors,

Fig. 2     shows schematically and exemplarily a device comprising a single superconductor with end parts approaching each other at a single location, wherein at this single location an oscillating part of superconducting material is arranged between the two end parts of the single superconductor,

Fig. 3     shows schematically and exemplarily a device comprising a plurality of superconductors approaching respective neighbors in a "star-like" configuration, wherein, at each location where respective two neighboring superconductors approach each other, an oscillating part of superconducting material is arranged between them,

Fig. 4     shows schematically and exemplarily an integration of any of the devices of Figs. 1, 2 and 3 into an electric circuit, and

Fig. 5     shows schematically and exemplarily physical characteristics of a system as shown in Fig. 4, as detailed further below.

DETAILED DESCRIPTION OF EMBODIMENTS

Fig. 1 shows schematically and exemplarily a device comprising a first superconductor 1 and a second superconductor 2, wherein the first superconductor 1 and the second superconductor 2 are formed non-integrally with each other. In this embodiment, the two superconductors 1, 2 have a same shape, the shape being describable as a semicircle with an outward extension halfway between the two ends of the semicircle. The outward extension can be electrically connected to a rest of a superconducting circuit, as will be described further below. The two superconductors 1, 2 are in this embodiment arranged symmetrically so as to oppose each other with their respective semicircle ends approaching each other. Thus, a configuration of superconducting material is provided that is describable as a circle, or circular ring, with respective gaps at diametrically opposing angular positions and outward extensions extending from the circle or circular ring at angular positions diametrically opposing each other and lying, in angular direction, halfway between the gaps, i.e., displaced from the gaps by 90 degrees.

Between each of the pairs 10, 20 and 40, 50 of semicircle ends of the superconductors 1, 2, a respective third part 30, 60 of superconducting material is arranged such that it is capable of carrying out mechanical oscillations. The third parts 30, 60 could also be referred to as superconducting islands. When, for instance, referring to the semicircle end 10 of the first superconductor as a first part 10 and to the semicircle end 20 of the second superconductor 2 as second part, the third part 30 of superconducting material is arranged such that it is capable of carrying out mechanical oscillations between the first part 10 and the second part 20. Similarly, at the diametrically opposing angular position of the ring-like arrangement of superconducting material, the other semicircle end 40 of the superconductor 1 and the other semicircle end 50 of the superconductor 2 respectively form a first part 40 and a second part 50 of superconducting material, wherein the third part 60 of superconducting material is arranged such that it is capable of carrying out mechanical oscillations between the first part 40 and the second part 50. Hence, in this embodiment, two sets of a respective first part, a respective second part and a respective third part of superconducting material are provided at two locations of the device. The two sets, which are respective versions of a same or similar arrangement of superconducting material, are in this case furthermore formed by an equal number of superconductors, namely the two superconductors 1, 2.

Each of the third parts 30, 60 of superconducting material is arranged such that it forms a respective first Josephson junction 13, 46 with the respective first part 10, 40 of superconducting material of the first superconductor 1 and a respective second Josephson junction 32, 65 with the respective second part 20, 50 of superconducting material of the second superconductor 2. Moreover, the respective third part 30, 60 is arranged such that the mechanical oscillations it is capable of carrying out change a respective physical dimension of the respective first Josephson junction 13, 46 and the respective second Josephson junction 32, 65. In particular, the respective third part 30, 60 can oscillate between the respective first part 10, 40 and the respective second part 20, 50 such that the distances between the respective third part 30, 60 and each of the respective first part 10, 40 and the respective second part 20, 50 change with the oscillations. Hence, the oscillations of the third parts 30, 60 affect the characteristics of the Josephson junctions 13, 32, 46, 65.

Fig. 2 illustrates schematically and exemplarily an embodiment being a variant of the embodiment shown in Fig. 1, the difference being that, in the embodiment shown in Fig. 2, only a single version of the arrangement of a first part, a second part and a third part of superconducting material is present in the device. In this case, instead of two separate superconductors 1, 2, a single superconductor 12 is used, such that the (single) first part 10 and the (single) second part 20 of superconducting material are parts of a same superconductor. The arrangement of superconducting material according to this second embodiment might still be regarded as being symmetric, but the symmetry is only present with respect to one axis (or plane perpendicular to the viewing plane in Figs. 1 and 2). Concretely, while the first embodiment, which has been described with reference to Fig. 1, might be regarded as being symmetric to both an axis diametrically intersecting the circle formed by the superconductors 1, 2 through the gaps in the circle and with respect to an axis diametrically intersecting the circle and being rotated with respect to the first mentioned axis by 90 degrees, the arrangement of superconducting material according to the embodiment of Fig. 2 might be regarded as being only symmetric with respect to the first mentioned axis, which in this case diametrically intersects the circle formed by the superconductor 12 at the (single) gap in the circle.

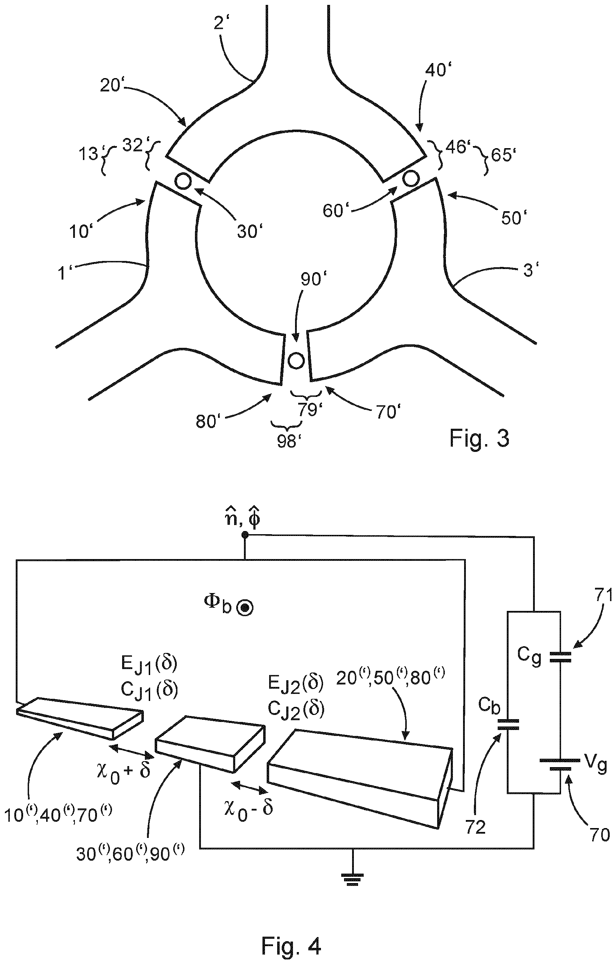

Fig. 3 illustrates schematically and exemplarily an embodiment being a further variant of the embodiment shown in Fig. 1. Like in the embodiment of Fig. 1, more than one version of an arrangement of a first, a second and third part of superconducting material is formed by an equal number of superconductors. However, in this case, the number of versions of the arrangement and of superconductors forming the same is equal to three.

Fig. 3 shows three superconductors 1', 2', 3' that are shaped essentially equal to each other, wherein the shape differs from the shape of the superconductors 1, 2 shown in Fig. 1 in that the arc-shaped portion of the shape is shortened from being essentially semicircular to essentially forming a third of a circle. The three superconductors 1', 2', 3' can in this way be arranged so as to jointly form a ring-like configuration with outward extensions extending from the circle at equidistant angular positions. In angular direction halfway between the positions of the outward extensions, i.e., again at equidistant angular positions, a respective arrangement of a first part, a second part and a third part of superconducting material can be identified.

Concretely, the superconductors 1', 2' form, with their respective end parts approaching each other, a first part 10' and a second part 20', respectively, of superconducting material, wherein a third part 30' of superconducting material is arranged such that it can oscillate between the two parts 10', 20' and forms respective oscillating Josephson junctions 13', 32' with the two parts 10', 20'. Similarly, the superconductors 2', 3' form, with their respective end parts approaching each other, a first part 40' and a second part 50', respectively, of superconducting material, wherein a third part 60' of superconducting material is arranged such that it can oscillate between the two parts 40', 50' and forms respective oscillating Josephson junctions 46', 65' with the two parts 40', 50'. Furthermore, the superconductors 3', 1' form, with their respective end parts approaching each other, a first part 70' and a second part 80', respectively, of superconducting material, wherein a third part 90' of superconducting material is arranged such that it can oscillate between the two parts 70', 80' and forms respective oscillating Josephson junctions 79', 98' with the two parts 70', 80'.

Fig. 3 serves to illustrate "star-like" device configurations, and thus exemplifies that the device is not limited to ordinary SQUID-type geometries. In other "star-like" device configurations, the number of locations where a third part of superconducting material is arranged between a first and a second part to form two Josephson junctions, and the equal number of superconductors approaching each other at the respective locations, would be four or higher.

The outward extensions of the superconducting material indicated in Figs. 1, 2, and 3 can be used for integrating the shown arrangements of superconducting material as part of an electrical circuit. This is shown schematically and exemplarily in Fig. 4.

In Fig. 4, a first part 10$^{(')}$, 40$^{(')}$, 70' of superconducting material, a second part 20$^{(')}$, 50$^{(')}$, 80' of superconducting material and a third part $30^{(')}$, $60^{(')}$, 90' of superconducting material is shown. The first part $10^{(')}$, $40^{(')}$, 70' could refer to each of the ends 10, 40 of the first superconductor 1 and/or to the superconductor 1 as a whole, or to the end 10 of the superconductor 12. Similarly, the second part $20^{(')}$, $50^{(')}$, 80' could refer to each of the ends 20, 50 of the second superconductor 2 and/or to the second superconductor 2 as a whole, or to the end 20 of the superconductor 12. The third part $30^{(')}$, $60^{(')}$, 90', accordingly, could refer to any of the third parts 30, 60 arranged at the diametrically opposing positions according to the embodiment of Fig. 1, or to the third part 30 shown in Fig. 3. Likewise, and with reference to the embodiment of Fig. 3, the first part $10^{(')}$, $40^{(')}$, 70' could refer to any of the first parts 10', 40', 70' and/or the respective superconductors 1', 2', 3', the second part $20^{(')}$, $50^{(')}$, 80' to any of the second parts 20', 50', 80' and/or a respective neighboring one of the superconductors 1', 2', 3', and the third part $30^{(')}$, $60^{(')}$, 90' to a respective third part 30', 60', 90'.

The electric circuit, which is shown in Fig. 4 in terms of a lumped-element model, comprises a voltage source 70 that is electrically connected to the at least one first part $10^{(')}$, $40^{(')}$, 70' and the at least one second part $20^{(')}$, $50^{(')}$, 80' of superconducting material, wherein the voltage source 70 is controllable to generate a voltage between a) the at least one first part $10^{(')}$, $40^{(')}$, 70' and the at least one second part $20^{(')}$, $50^{(')}$, 80' and b) the at least one third part $30^{(')}$, $60^{(')}$, 90', wherein the one or more third parts $30^{(')}$, $60^{(')}$, 90' are electrically grounded. In particular, the voltage source 70 is electrically connected to the at least one first part $10^{(')}$, $40^{(')}$, 70' and the at least one second part $20^{(')}$, $50^{(')}$, 80' of superconducting material through a first capacitance providing element 71. Furthermore, the electric circuit comprises a second capacitance providing element 72, wherein the second capacitance providing element 72 is electrically installed in parallel to the first capacitance providing element 71 and the voltage source 70, wherein the voltage source 70 and the second capacitance providing element 72 are electrically grounded to a common ground, to which also the one or more third parts $30^{(')}$, $60^{(')}$, 90' may be connected. The voltage source 70 could also be regarded as a gate voltage $V_g$, the first capacitance providing element as a gate or gating capacitance $C_g$, and the second capacitance providing element as a shunting capacitance Cb.

The electric circuit is configured such that the first capacitance providing element 71 and the second capacitance providing element 72 are connected to the parts $10^{(')}$, $40^{(')}$, 70', $20^{(')}$, $50^{(')}$, 80' of superconducting material via a same connection, particularly such that the at least one first part $10^{(')}$, $40^{(')}$, 70' is electrically connected to the at least one second part $20^{(')}$, $50^{(')}$, 80' via an electric connection that itself is connected to each of the first and the second capacitance providing element.

As indicated in Fig. 4, the at least one third part $30^{(')}$, $60^{(')}$, 90' of superconducting material may carry out its mechanical oscillations around an equilibrium position between the respective first part $10^{(')}$, $40^{(')}$, 70' and the respective second part $20^{(')}$, $50^{(')}$, 80' of superconducting material. In equilibrium, the distance between the respective third part $30^{(')}$, $60^{(')}$, 90' to each of the respective first part $10^{(')}$, $40^{(')}$, 70' and the respective second part $20^{(')}$, $50^{(')}$, 80' would then be a respective equilibrium distance $x_0$. The oscillations would then lead to displacements $\delta$ out of the equilibrium. Fig. 4 illustrates, for instance, a point in time during the oscillations at which the respective third part $30^{(')}$, $60^{(')}$, 90' is displaced by $\delta$ towards the respective second part $20^{(')}$, $50^{(')}$, 80', such that the distance to the respective first part $10^{(')}$, $40^{(')}$, 70' is increased from $x_0$ to $x_0+\delta$ and the distance to the respective second part $20^{(')}$, $50^{(')}$, 80' is decreased from $x_0$ to $x_0-\delta$. This is associated with changes in the energies $E_{J1}(\delta)$, $E_{J2}(\delta)$ and the capacitances $C_{J1}(\delta)$, $C_{J2}(\delta)$ attributable to the respective first and second Josephson junctions, with the displacement $\delta$. As also seen in Fig. 4, the respective third part $30^{(')}$, $60^{(')}$, 90' of superconducting material is preferably electrically grounded.

Fig. 4 also indicates an external magnetic flux $\Phi_b$ piercing the loop formed by the part of the electric circuit comprising the superconducting material. This magnetic flux is generated using a field generating element for generating a magnetic field corresponding to the magnetic flux. The field generating element can be part of a control apparatus for controlling the device, wherein the control apparatus may further comprise a control unit configured to control a state of the device. For quantum applications of the device, the control unit may be configured to control the state of the device based on a model of the device, wherein the model represents the device as a superconducting circuit coupled to a mechanical oscillator such that the coupling depends on the magnetic flux, wherein the control unit is configured to control a state of the device by controlling the coupling between the superconducting circuit and the mechanical oscillator using the field generating element.

The model is based on the following Hamiltonian:

$$H = 4E_{\mathrm{C}}(\delta)(n - n_{\mathrm{g}})^2 - E_{\Sigma}(\delta)\cos\left(\frac{\phi_{\mathrm{b}}}{2}\right)\cos(\phi)$$

$$- E_{\Delta}(\delta)\sin\left(\frac{\phi_{\mathrm{b}}}{2}\right)\sin(\phi) + E\left(x_{\mathrm{m}}, p_{\mathrm{m}}\right),$$

wherein:

- $E_C(\delta)$ refers to the charging energy of the circuit and can be written

$$E_C = \frac{e^2}{2C_\Sigma}$$

with

$$C_\Sigma = C_{J1} + C_{J2} + C_b + C_g \, ,$$

where $C_{J1}$ and $C_{J2}$ are the capacitances of the respective two Josephson junctions, $C_g$ the gate capacitance, i.e., the capacitance of the first capacitance providing element 71, and $C_b$ the shunting capacitance, i.e., the capacitance of the second capacitance providing element 72, and wherein the capacitances $C_{J1}$ and $C_{J2}$ associated with the Josephson junctions may be modelled by two (equal, parallel plate) capacitors, i.e., it may be assumed that $C_{J1,2} = \frac{c_J}{1 \pm \frac{\delta}{x_0}}$ ,

- $n$ refers to an excess number of charge carriers on the respective third part 30, 60 of superconducting material, with $n_g$ serving as a reference charge and being related to the external voltage $V_g$, which may also be regarded as an external bias voltage $V_g$, by $n_g = -C_g V_g/2e$ ,

- $E_\Sigma(\delta)$ refers to the sum of the respective two Josephson energies, i.e., $E_\Sigma(\delta) = E_{J1}(\delta) + E_{J2}(\delta)$, wherein the Josephson energies are assumed to satisfy

$$E_{J1,2} = E_J \exp\left[\mp\frac{\delta}{\xi}\right]$$

with $\xi = \frac{x_0}{\log(\Delta R_K/(8E_{J0}R_{N0}))}$ and $E_J = E_{J1}(0) = E_{J2}(0)$ for symmetrical Josephson junctions, and wherein $\Delta$ is the superconducting gap and $R_K = 2\pi\hbar/e^2$ the resistance quantum (for Josephson junctions of the type NbN, $\xi$ can be estimated to $\xi \simeq 0.1$ nm),

- $\phi$ refers to the superconducting phase on the respective third part 30, 60 of superconducting material, with $\phi_b$ being determined by the (external) magnetic flux by $\Phi_b = \Phi_0/2\pi\phi_b$ (with $\Phi_0 = h/2e$),

- $E_\Delta(\delta)$ refers to the difference between the two Josephson energies, i.e., $E_\Sigma(\delta) = E_{J1}(\delta) - E_{J2}(\delta)$, and

- the term $E(x_m, p_m)$ refers to an energy associated with the dynamics of the center of mass of the respective third part 30$^{(')}$, 60$^{(')}$, 90' of superconducting material.

In order to treat the superconducting circuit as a qubit and the mechanical oscillator as a quantum harmonic oscillator, the above Hamiltonian can be expanded in powers of $\hat{\phi}$ up to the fourth order and in powers of the mechanical displacement up to the second order. Focusing on the two lowest-charge states, a Hamiltonian of the following form can thus be derived:

$$H = \frac{\omega_q}{2}\sigma_z + \omega_m b^\dagger b \\ + g_1(b^\dagger + b)\sigma_x + g_2(b^\dagger + b)^2\sigma_z \, ,$$

where $\sigma_z = 2a^\dagger a - 1$, $\sigma_x = a^\dagger + a$, with the operators $a$, $(a^\dagger)$, $b$, $(b^\dagger)$ being the lowering (and, respectively, raising) operators associated with the electrical and the mechanical degrees of freedom, respectively, and where the coefficients $\omega_q, \omega_m, g_1, g_2$ depend on the external flux bias $\Phi_b$.

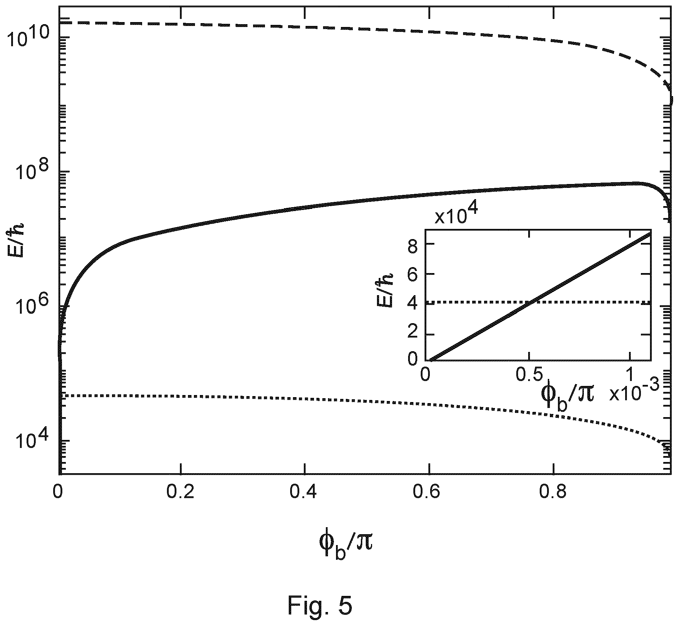

As seen in Fig. 5, $g_2$ is the dominating interaction when the bias flux through the superconducting loop with the Josephson junctions is set to zero, since $g_1$ vanishes in this case. However, $g_1$ becomes the dominating term even for small deviations from the $\Phi_b = 0$ condition. This ability to control the type of interaction between the qubit and the mechanics makes the device presented herein very flexible in terms of possible applications, such as preparing the mechanical oscillator into a specific quantum state. In Fig. 5, the solid and the dotted line indicate the couplings $g_1$ and $g_2$, respectively, as a function of the external flux $\phi_b$, and the dashed line indicates the dependence of the qubit energy $\omega_q$ on $\phi_b$. Fig. 5 applies to an exemplary combination of parameter values, but is nevertheless considered representative for the "tunability" of the device.

Hence, it has been observed that a device as presented herein can exhibit a quadratic coupling of a qubit to a mechanical motion, in addition to a tunable linear one. The latter can be externally suppressed, leading to a dominant coupling that is quadratic in the mechanical degrees of freedom, which can be advantageous for many applications. At the same time, it has been found that the tunability of the linear coupling allows for a coherent state exchange between the qubit and the mechanical resonator.

As will be understood, the control unit of the control apparatus is not only configured to use the field generating element to "tune" the device via the external magnetic flux, but also to use the voltage source to further "tune" the device via voltages $V_g$ generated across the respective Josephson junctions. In this way, both a flux bias and a charge bias may be used to control a state of the device.

Using several of the devices described herein as qubits controlled by a common control apparatus, a quantum computing apparatus, or quantum computer, could potentially be built in which the respective state of individual qubits could be manipulated via respective external fluxes $\phi_b$, and optionally also voltages $V_g$, for use in quantum computing.

Among the embodiments disclosed herewith, a device is presented that consists of a superconducting circuit in which a mechanical shuttle is embedded. The mechanical shuttle may correspond to the third part of superconducting material, wherein its "shuttle" property derives from the fact that it is capable of oscillating between a first and a second part of superconducting material. The device may be designed based on a Josephson junction with mechanically tunable tunneling barriers enabling electron (single Cooper pair) shuttling, i.e. transport. Different circuit topologies for such nano-mechanically tunable Josephson junctions are possible. In particular, we have exemplified here a possible transmon-like setup, defining a quantum device describable as a qubit coupled to a bosonic system (in this case a mechanical oscillator). The qubit/mechanics coupling is externally tunable, allowing the preparation of non-classical mechanical states which can be employed to protect quantum information against decoherence.

A promising application for the device and apparatus presented herein is bosonic error correction. On general grounds, bosonic error correction can provide key advantages over quantum error correction schemes utilizing multiple physical qubits, inasmuch it eliminates the overheads and the potential issues arising from cross-talk of multiple physical qubits. More specifically, a mechanical implementation as disclosed herein can lead to further advantages over, for instance, using a microwave cavity instead: mechanical resonators offer better ring-down times than microwave cavities, shuttling resonators offer a more compact design and relatively straightforward scalability, and the qubit/mechanics (linear) coupling can be externally tuned.

While, in the above, embodiments have been described in which a respective third part of superconducting material is arranged symmetrically between the respective first and second parts, this is not necessary. Also for embodiments that are asymmetric in this regard control models like the above-described ones can be derived. If the respective two Josephson junctions formed by the respective three parts of superconducting material exhibit some degree of asymmetry, a linear coupling to $\sigma_z$ and a quadratic coupling to $\sigma_x$ would appear in the above quantum-mechanical Hamiltonian, in addition to a small qubit rotation (zeroth-order term in $\sigma_x$). While the quadratic coupling to $\sigma_x$ is negligible for all parameters, the linear coupling between the displacement and $\sigma_z$ can become comparable to the quadratic one.

Other variations to the disclosed embodiments can be understood and effected by those skilled in the art in practicing the claimed invention, from a study of the drawings, the disclosure, and the appended claims.

In the claims as well as in the description the word "comprising" does not exclude other elements or steps. The indefinite article "a" or "an" and the definite article "the" does not exclude a plurality. In particular, the indefinite article "a" or "an" may be replaced with one or more and the definite article "the" may be replaced with the one or more. A single element or other unit may fulfill the functions of several entities or items recited in the claims. The mere fact that certain measures are recited in the mutual different dependent claims does not indicate that a combination of these measures cannot be used in an advantageous implementation.

Procedures like the generating of a magnetic field and the control of a state of the device presented herein, which can be performed by one or several elements, units or devices, can also be performed by any other number of units or devices. These procedures can be implemented as program code means of a computer program and/or as dedicated hardware. A computer program product may be stored/distributed on a suitable medium, such as an optical storage medium or a solid-state medium, supplied together with or as part of other hardware, but may also be distributed in other forms, such as via the Internet or other wired or wireless telecommunication systems.

Any disclosure and embodiments described herein relate to the methods, the systems, devices, any computer program element lined out above and vice versa. Advantageously, the benefits provided by any of the embodiments and examples equally apply to all other embodiments and examples and vice versa.

Any reference signs in the claims should not be construed as limiting the scope.

**Claims**

1. A device comprising a first part (10, 40), a second part (20, 50) and a third part (30, 60) of superconducting material, wherein the third part (30, 60) is arranged between the first part (10, 40) and the second part (20, 50) such that a first Josephson junction (13, 46) is formed by the first part (10, 40) and the third part (30, 60) and a second Josephson junction (32, 65) is formed by the second part (20, 50) and the third part (30, 60), wherein the third part (30, 60) is arranged such that it is capable of carrying out mechanical oscillations between the first part (10, 40) and the second part (20, 50), wherein the mechanical oscillations change a respective physical dimension of the first Josephson junction (13, 46) and the second Josephson junction (32, 65).

2. The device as defined in claim 1, wherein the first part (10, 40) is a part of a first superconductor (1) and the second part (20, 50) is a part of a second superconductor (2) formed non-integrally with the first superconductor (1).

3. The device as defined in claim 1 or 2, wherein the device comprises at least two sets (10, 20, 30; 40, 50, 60) of first parts, second parts and third parts, such that a respective version of the arrangement as defined in claim 1 is present at two or more locations of the device.

4. The device as defined in claim 3, wherein at least two versions of the arrangement as defined in claim 1 are formed by an equal number of superconductors (1, 2).

5. The device as defined in claim 1, wherein the first part (10, 40) and the second part (20, 50) are parts of a same superconductor (12).

6. The device as defined in any of the preceding claims, wherein the device further comprises a voltage source (70) electrically connected to the at least one first part (10, 40) and the at least one second part (20, 50) of superconducting material, wherein the voltage source (70) is controllable to generate and/or change a voltage between a) the at least one first part (10, 40) and/or the at least one second part (20, 50) and b) the at least one third part (30, 60).

7. The device as defined in claim 6, wherein the device further comprises a first capacitance providing element (71) through which the voltage source (70) is electrically connected to the at least one first part (10, 40) and the at least one second part (20, 50) of superconducting material.

8. The device as defined in claim 6 or 7, wherein the electric connection between a) the voltage source (70) and b) the at least one first part (10, 40) and the at least one second part (20, 50) of superconducting material comprises a second capacitance providing element (72), wherein the second capacitance providing element (72) is electrically installed in parallel to the first capacitance providing element (71).

9. A control apparatus for controlling the device as defined in any of the preceding claims, wherein the control apparatus comprises:

   - a field generating element for generating a magnetic field corresponding to a magnetic flux through the device, and
   - a control unit configured to control a state of the device based on a model of the device, wherein the model represents the device as a superconducting circuit coupled to a mechanical oscillator such that the coupling depends on the magnetic flux, wherein the control unit is configured to control the state of the device by controlling the coupling between the superconducting circuit and the mechanical oscillator using the field generating element.

10. The control apparatus as defined in claim 9, for controlling the device as defined in any of claims 6 to 8, wherein the control unit is further configured to use the voltage source for controlling the state of the device via the coupling between the superconducting circuit and the mechanical oscillator.

11. The control apparatus as defined in claim 8 or 9, wherein the model treats the superconducting circuit as a qubit and the mechanical oscillator as a quantum harmonic oscillator.

12. A quantum computing apparatus comprising the device as defined in any of claims 1 to 8 and the control apparatus as defined in claim 11.

13. A control method for controlling the device as defined in any of claims 1 to 8, including steps of:

- generating a magnetic field corresponding to a magnetic flux through the device, and
- controlling a state of the device based on a model of the device, wherein the model represents the device as a superconducting circuit coupled to a mechanical oscillator such that the coupling depends on the magnetic flux, wherein the control unit is configured to control the state of the device by controlling the coupling between the superconducting circuit and the mechanical oscillator using the magnetic field.

14. Use of the quantum computing apparatus as defined in claim 12 for quantum computing.

Fig. 1

Fig. 2

Fig. 3

Fig. 4

Fig. 5

Europäisches
Patentamt

European
Patent Office

Office européen
des brevets

## EUROPEAN SEARCH REPORT

**Application Number**

EP 24 15 9680

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ERIKSSON A M ET AL: "Zero-phase-difference Josephson current based on spontaneous symmetry-breaking via parametric excitation of a movable superconducting dot", ARXIV.ORG, CORNELL UNIVERSITY LIBRARY, 201 OLIN LIBRARY CORNELL UNIVERSITY ITHACA, NY 14853, 20 January 2017 (2017-01-20), XP080750465, | 1,2,6 | INV. H10N60/12 H10N69/00 G06N10/40 |
| A | * the whole document * | 3-5,7-14 | |
| X | FRANSSON J ET AL: "Vibrating Superconducting Island in a Josephson Junction", ARXIV.ORG, CORNELL UNIVERSITY LIBRARY, 201 OLIN LIBRARY CORNELL UNIVERSITY ITHACA, NY 14853, 3 July 2007 (2007-07-03), XP080292016, DOI: 10.1103/PHYSREVLETT.101.067202 | 1,2,6 | |
| A | * the whole document * | 3-5,7-14 | |
| X | GORELIK L Y ET AL: "Coherent transfer of Cooper pairs by a movable grain", ARXIV.ORG, CORNELL UNIVERSITY LIBRARY, 201 OLIN LIBRARY CORNELL UNIVERSITY ITHACA, NY 14853, 12 December 2000 (2000-12-12), XP080036554, DOI: 10.1038/35078027 | 1,2,6 | **TECHNICAL FIELDS SEARCHED (IPC)** H10N G06N |
| A | * the whole document * | 3-5,7-14 | |

The present search report has been drawn up for all claims

| Place of search | Date of completion of the search | Examiner |
|---|---|---|
| Munich | 12 July 2024 | Steiner, Markus |

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **D.V. SCHEIBLE** ; **R.H. BLICK**. A Mode Locked Nanomechanical Electron Shuttle. *New Journal of Physics*, 12 January 2010, 023019
- **C. KIM** ; **H.S. KIM** ; **H. QIN** ; **R.H. BLICK**. Coulomb-controlled Single Electron Field Emission from a Freely Suspended Metallic Island. *Nano Letters*, 2010, vol. 10, 615
- **D.V. SCHEIBLE** ; **CH. WEISS** ; **J.P. KOTTHAUS** ; **R.H. BLICK**. Periodic Field Emission from an Isolated Nanoscale Electron Island. *Physical Review Letters*, 2004, vol. 93, 186801
- **D.V. SCHEIBLE** ; **CH. WEISS** ; **R.H. BLICK**. Effects of Low Attenuation in a Nanomechanical Electron Shuttle. *Journal of Applied Physics*, 2004, vol. 96, 1757
- **ROBERT H. BLICK** ; **D.V. SCHEIBLE**. A Quantum Electro Mechanical Device: The Electro-Mechanical Single Electron Pillar. *Superlattices and Microstructures*, 2004, vol. 33, 397
- **D.V. SCHEIBLE** ; **R.H. BLICK**. Silicon Nano-Pillars for mechanical single electron transport. *Applied Physics Letters*, 2004, vol. 84, 4632